Europäisches Patentamt

European Patent Office

Office européen des brevets

(11) Publication number: **0 056 690**
**B1**

# EUROPEAN PATENT SPECIFICATION

(45) Date of publication of patent specification: **16.05.84**

(51) Int. Cl.³: **H 03 H 9/25**, H 03 H 9/64

(21) Application number: **82300077.3**

(22) Date of filing: **07.01.82**

(54) **Surface acoustic wave resonator device.**

(30) Priority: **19.01.81 JP 5166/81**

(43) Date of publication of application:
**28.07.82 Bulletin 82/30**

(45) Publication of the grant of the patent:
**16.05.84 Bulletin 84/20**

(84) Designated Contracting States:
**DE FR GB IT NL**

(56) References cited:
**EP-A-0 006 054**
**EP-A-0 024 927**
**EP-A-0 051 942**
**FR-A-2 379 941**
**US-A-3 886 504**
**US-A-4 151 492**

(73) Proprietor: **TOKYO SHIBAURA DENKI KABUSHIKI KAISHA**
**72, Horikawa-cho Saiwai-ku**
**Kawasaki-shi Kanagawa-ken 210 (JP)**

(72) Inventor: **Morishita, Shigefumi c/o Patent Division**
**Tokyo Shibaura Denki K.K. 72, Horikawa-cho**
**Saiwai-ku Kawasaki-shi Kanagawa-ken, 210 (JP)**
Inventor: **Ebata, Yasuo c/o Patent Division**
**Tokyo Shibaura Denki K.K. 72, Horikawa-cho**
**Saiwai-ku Kawasaki-shi Kanagawa-ken, 210 (JP)**

(74) Representative: **Batchellor, John Robert et al**
**BATCHELLOR, KIRK & EYLES 2 Pear Tree Court**
**Farringdon Road**
**London EC1R 0DS (GB)**

Courier Press, Leamington Spa, England.

## Description

This invention relates to a surface acoustic wave resonator device having a grating reflector, and more particularly to such a resonator device used as a bandpass filter, an oscillator frequency control element or the like.

There is frequently a requirement in communications and other electronic fields for a bandpass filter or an oscillator frequency control element having a narrow frequency range. Surface acoustic wave resonator devices may fulfil such a requirement and various surface acoustic wave resonators have been developed.

French Specification No. 2,379,941 (British Patent No. 1,554,366) describes a surface acoustic wave device consisting basically of a piezoelectric substrate, a plurality of interdigitated transducers disposed on the piezoelectric substrate for converting an input electric signal to surface acoustic waves propagating on the surface of the piezoelectric substrate, and grating reflectors for reflecting the surface acoustic waves. The reflectors have an aperture width extending at least the width of the acoustic wave propagation paths. This kind of surface acoustic wave resonator device is also described, for example in U.S. Patents Nos. 3,886,504 and 4,166,258.

The impedance of such a resonator device must be designed in accordance with the impedance of an external circuit to be connected thereto. Both high impedance and low impedance resonator devices are consequently frequently required. The optimal impedance of a surface acoustic wave resonator is inversely related to the aperture length of the interdigital transducer as described in a paper entitled "SURFACE ACOUSTIC WAVE RESONATOR DEVELOPMENT" by J. S. Schoenwald et al. presented at *Proc. of the 29th Annual Symp. on Frequency Control*, page 150—157, May 1975. Accordingly, a surface acoustic wave resonator device having high impedance may be obtained by decreasing the aperture length of the interdigital transducer. However, decreasing the aperture length of the interdigital transducer results in reducing the resonance factor Q of the resonator device because a beam of the surface acoustic waves propagating on the piezoelectric substrate expands out of the resonance region by diffraction and energy loss increases. Moreover, it is difficult to manufacture interdigital transducers having small aperture length.

It is an object of this invention to provide a surface acoustic wave resonator device having high impedance as well as a high Q.

According to the present invention, a surface acoustic wave resonator device comprising: a substrate comprising or including a layer of piezoelectric material; at least one transducer means disposed on the surface of the piezoelectric layer for converting an input electrical signal to surface acoustic wave propagating on the piezoelectric surface, the transducer means comprising a plurality of interdigitated transducers and grating reflector means disposed on the piezoelectric surface for reflecting the surface acoustic waves so that they can resonate, the aperture length of the grating reflector means extending over at least the width of the surface acoustic wave propagation paths, is characterised in that, the plurality of interdigitated transducers are electrically connected to each other in series between terminals to which the input electrical signal is applied and are physically aligned to form surface acoustic wave propagation paths parallel to each other.

A particular form of the invention provides a surface acoustic wave resonator device comprising: a piezoelectric substrate; an input transducer means disposed on the piezoelectric substrate for converting an input electrical signal to surface acoustic waves propagating on the piezoelectric substrate; an output transducer means disposed on the piezoelectric substrate in a face to face relationship with the input transducer for converting the surface acoustic waves to an electric signal, at least one of the transducer means comprising a plurality of interdigitated transducers and first and second grating reflectors disposed on the piezoelectric substrate with the input and output transducer means therebetween, for reflecting the surface acoustic waves, the aperture length of the first and second grating reflectors extending over at least the width of said surface acoustic wave propagation paths, characterised in that, said plurality of interdigitated transducers are electrically connected to each other in series and are physically aligned in a direction perpendicular to the surface wave propagation path.

The invention will be more readily understood by way of example from the following description of surface acoustic resonators in accordance therewith, reference being made to the accompanying drawings, in which

Figure 1 is a perspective view of a one-port type surface acoustic wave resonator device;

Figure 2 graphically illustrates the variation of Q factor of a surface acoustic wave resonator device with aperture length;

Figure 3 is a perspective view of a two-port type surface acoustic wave resonator device;

Figure 4 is a perspective view of a second form of the two-port type surface acoustic wave resonator device;

Figure 5 graphically illustrates the insertion loss versus frequency characteristic of a prior art surface acoustic wave resonator device;

Figure 6 is a plan view of another form of one-port type surface acoustic wave resonator device;

Figure 7 graphically illustrates the insertion loss versus frequency characteristic of the device of Figure 6; and

Figure 8 is a plan view of further form of the two-port type surface acoustic wave resonator device.

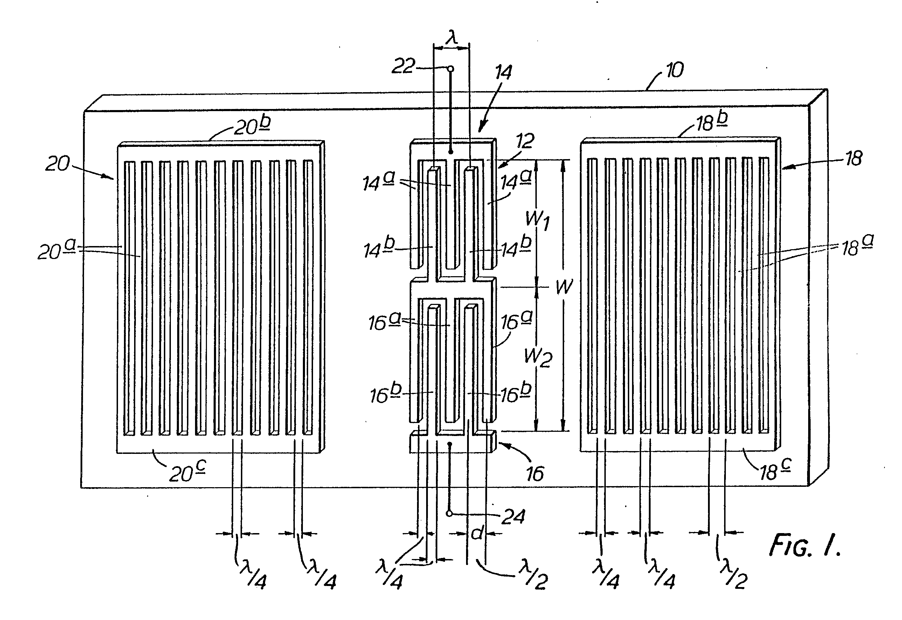

Figure 1 shows a surface acoustic wave resonator which may have an impedance twice that of a conventional surface wave resonator having a single transducer of aperture length $W_1$, and impedance Z. This resonator has a substrate 10 made of piezoelectric material such as lithium tantalate, lithium niobate or quartz. Positioned on substrate 10 is transducer means 12 which includes first and second interdigitated transducers 14 and 16. First transducer 14 includes a first electrode 14a and a second electrode 14b. These electrodes have many finger electrodes with the finger electrodes of electrode 14a interdigitated with those of electrode 14b. Similarly, second transducer 16 includes first and second electrodes 16a and 16b which have many finger electrodes similarly arranged in interdigitated relationship.

First and second transducers 14 and 16 are aligned such that the surface acoustic waves generated by first and second interdigital transducers 14 and 16 propagate in the same direction and the phases of those surface acoustic waves correspond to each other. Accordingly, two surface acoustic wave propagation paths parallel to each other are formed.

The second electrode 14b of first transducer 14 is formed integrally with the first electrode 16a of the second transducer 16 and is connected thereto electrically. Accordingly, first and second transducers 14 and 16 are connected to each other in series.

The electrodes 14a, 14b, 16a and 16b may be formed of a suitable patterned thin film electrically conductive material such as aluminium, gold or copper. Although electrodes 14a, 14b, 16a and 16b are illustrated in Figure 1 as having three or two fingers each, it should be understood that each electrode may have a larger number of fingers. Each finger has a width which equals $\lambda/4$ and the pitch of the finger on the same electrode is equal to $\lambda$, where $\lambda$ is the wave length of the generated surface acoustic wave. Accordingly, the pitch of the interdigitated fingers is $\lambda/2$. The aperture length W of transducer 12 is preferably the sum of aperture lengths $W_1$ and $W_2$ ($=W_1$) of first and second transducers 14 and 16 respectively. Each aperture length W of transducers 14 and 16 is the same as that of the conventional transducer which has the aperture length $W_1$ and impedance Z.

Substrate 10 also carries reflector means constituted by a pair of grating reflectors 18 and 20 positioned on opposite sides of transducer means 12. Grating reflector 18 includes parallel spaced reflecting elements 18a which are interconnected at their opposite ends by conductors 18b and 18c. Likewise, grating reflectors 20 includes parallel spaced reflecting elements 20a, and conductors 20b and 20c for interconnecting parallel spaced conductors 20a.

These grating reflectors 18 and 20 may be also formed of thin films such as aluminium, gold, copper, etc. Each parallel spaced reflecting element 18a has a width which equal $\lambda/4$ and the spacing between adjacent reflecting elements is equal to $\lambda/2$. The aperture length of grating reflector 18 is equal to the aperture length W of transducer 12. Grating reflector 20 is formed in a manner similar to grating reflector 18. Each grating reflectors 18 and 20 is illustrated in Figure 1 as having twelve parallel reflecting elements, but it should be understood that each may have a larger number of parallel reflecting elements, for example, usually 200 elements.

In operation an input electrical signal is supplied between a terminal 22 connected to first electrode 14a of first interdigital transducer 14 and a terminal 24 connected to a second electrode 16b of second interdigital transducer 16. This input electrical signal is converted by transducer 12 to surface acoustic wave energy propagating along the surface of substrate 10 normal to the transducer means 12. As these propagating surface waves reach reflecting elements 18a and 20a of grating reflectors 18 and 20, each of which has an aperture length extending over at least the width of the surface acoustic wave propagation path, the waves are at least partially reflected by each of the reflecting elements 18a and 20a. The individual reflecting elements 18a and 20a of each of grating reflectors 18 and 20 are equispaced, and the distance between centres of adjacent reflecting elements is equal to one-half wave length at the central frequency of the resonator device. As a result, the waves reflected from reflecting elements 18a and 20a of grating reflectors 18 and 20 reinforce in coherent manner. If a suitably large number of reflective reflecting elements are provided, almost total reflection of the incident acoustic waveform occurs. The presence of two grating reflectors 18 and 20 on the surface of substrate 10 results in a standing wave resonance being set up between the two reflected waves. In order to obtain proper realization of this standing wave resonance the two grating reflectors 18 and 20 are separated by approximately an integral number of half-wave lengths along the surface of substrate 10.

The impedance of the surface acoustic wave resonator device having grating reflectors is inversely related to the aperture length of the transducer means. Accordingly, if it was required to double the impedance of the conventional resonator device having a single aperture length $W_1$, it has been previously necessary to halve the aperture length $W_1$ to $W_1/2$. How-ever, reducing the aperture length resulted in a reduction of the Q of the resonator device.

In accordance with the resonator device of the present invention, first and second interdigital transducers 14 and 16 each having the

aperture lengths $W_1$ are designed. Therefore, the impedances of first and second interdigital transducers 14 and 16 are Z, respectively. However, first and second interdigital transducers are connected in series. Accordingly, the total impedance of the resonator device is 2Z. Moreover, the total aperture length W of transducer 12 is $2W_1$. As a result, the illustrated surface acoustic wave resonator device has not only high impedance but also a high resonance factor Q.

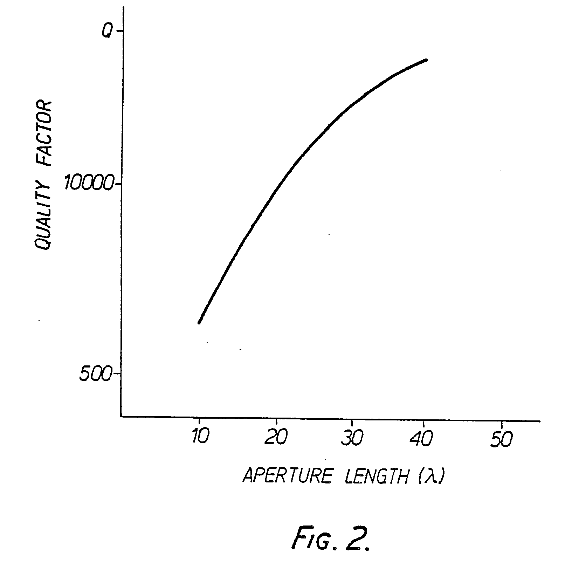

Figure 2 is a graph showing the relationship between the aperture length $W_1$ and Q factor of a conventional resonator device which includes a transducer having 11 pairs of fingers and grating reflectors having 200 reflecting elements, respectively, on a lithium tantalate ($LiTaO_3$) substrate. In Figure 2, when the aperture length $W_1$ is $20\lambda$, the quality factor Q is about 9700.

If a resonator device having an impedance twice as much as the above mentioned resonator device was required, the aperture length of the resonator device had to be reduced to $10\lambda$ in the prior art. However, the Q factor of such a resonator device is reduced to about 6500.

The resonator device of the present invention may have the aperture length $40\lambda$ and still have an impedance twice as much as above mentioned resonator device. Accordingly, the quality factor of the resonator device according to the present invention increases to about 13000.

Instead of having the transducer means constituted by two series-connected transducers as in Figure 1, the transducer means may be formed by three or more such transducers. The resulting resonator device then may have higher impedance and quality factor.

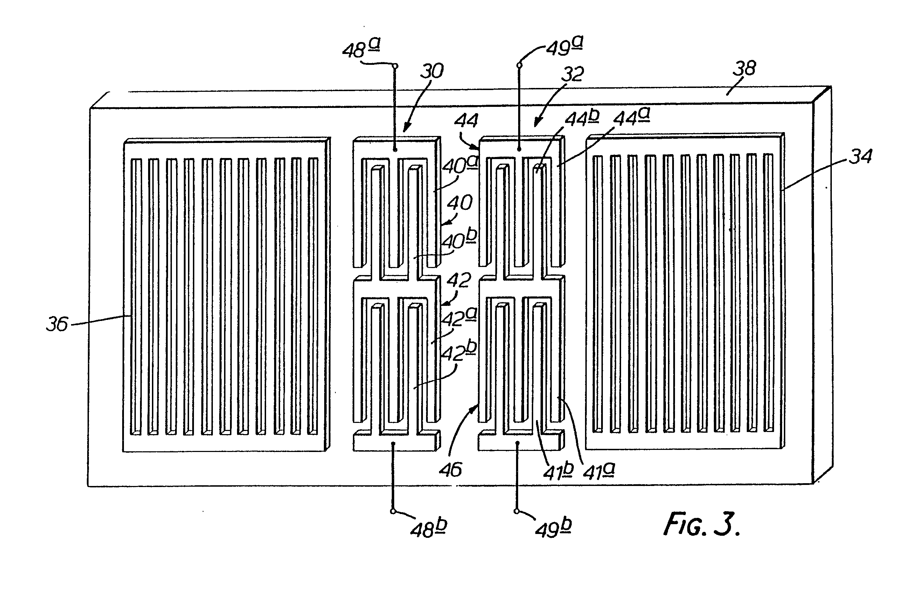

Figure 3 illustrates a two-port surface acoustic wave resonator device. This resonator device is similar to that illustrated in Figure 1 except that input and output transducer means 30 and 32 are disposed on the substrate 38 in the space between the grating reflectors 34 and 36. Input and output transducer means 30 and 32 each have the same configurations as the transducer 12 shown in Figure 1 and are positioned in a face to face relationship. Input transducer means 30 includes first and second interdigitated transducers 40 and 42 each of which has first and second electrodes 40a, 40b and 42a and 42b. Second electrode 40a of first interdigital transducer 40 is formed integrally with the first electrode 42a of second interdigital transducer 42 and is connected electrically thereto.

Similarly, output transducer means 32 includes first and second interdigital transducers 44 and 46 each of which has first and second electrodes 44a, 44b and 46a and 46b. An input electric signal is supplied between a terminal 48a connected to the first electrode 40a of first interdigital transducer 40 and a terminal 48b connected to the second electrode 42b of second interdigital transducer 42. Energy in the standing wave resonance is coupled by means of output interdigital transducer 32 to a load (not shown) connected between first electrode 44a of first interdigital transducer 44 and second electrode 46a of second interdigital transducer 46 through terminals 49a and 49b.

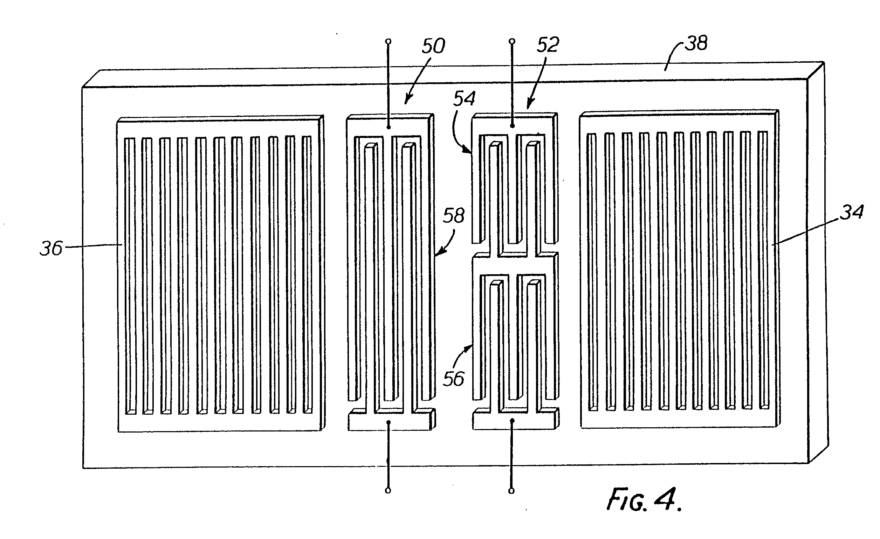

Figure 4 illustrates another two-port surface acoustic wave resonator device. The resonator device of this embodiment has input and output transducer means 50 and 52, the configurations of which are different. Output transducer means 52 includes two interdigital transducers 54 and 56 connected in series and each having aperture lengths W/2. Input transducer 50 includes only single interdigital transducer 58 having an aperture length W.

Such resonator device has an input impedance different from its output impedance. If the input impedance is denoted by Z and the output impedance is 4Z. As described above, input and output impedances of this resonator device may be designed individually. Accordingly, the impedance matchings between input transducer means 50 and a coupled external circuit, and between output transducer means 52 and a coupled external circuit may be carried out individually.

As alternative to the arrangement shown in Figure 4, the input and output transducer means may have numbers of series-connected interdigital transducers chosen to obtain desired impedances.

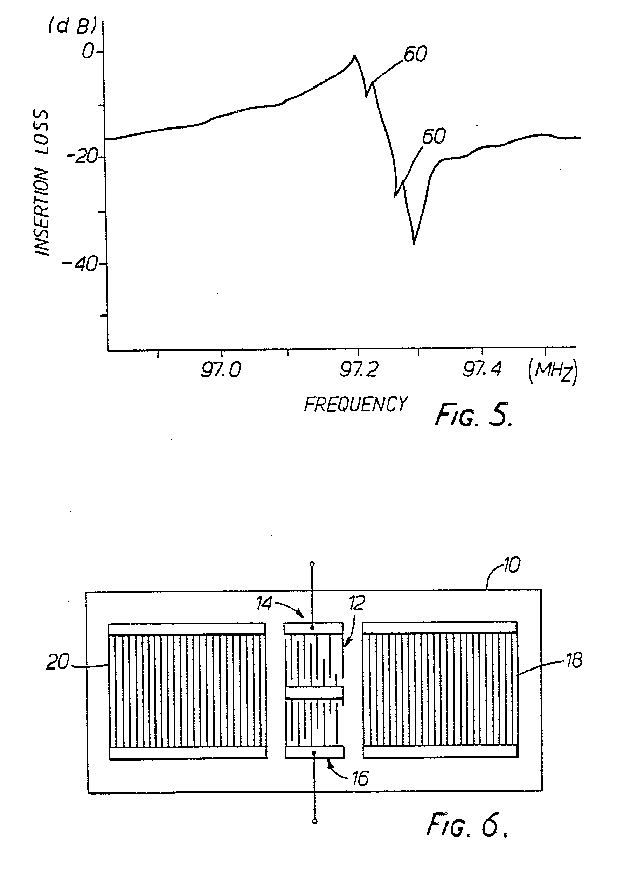

It is known that the surface acoustic waves generated by the transducer contain not only the fundamental mode wave but also higher transverse mode waves. The higher transverse mode waves cause spurious responses in the frequency characteristic of a surface acoustic wave resonator device as shown in Figure 5. The resonance frequency of the higher transverse mode wave varies in response to the aperture length of the grating reflectors. When the aperture length of the grating reflectors is long, there appear resonance points (spurious) shown in Figure 5 at 60. This disadvantage can be overcome by the arrangement shown in Figure 6.

The surface acoustic resonator device of this embodiment is similar to that illustrated in Figure 1 except that the overlap of consecutive finger electrodes of each transducer 14, 16 varies in the direction of the propagated waves, as shown. This variation in overlap along the transducer has been termed "apodization", and the resultant structures are called "apodized interdigitated transducers". However, the transducer means of this embodiment has two interdigital transducers connected in series which form a single apodized interdigital transducer. The variation in overlap is such that the energy distribution of the surface acoustic wave generated by the interdigital transducer is the same as that of the fundamental transverse mode wave. For example, the lengths of the finger electrodes of one electrode of each of transducers 14, 16 may vary according to the cosine of the distance of the electrodes from an end electrode.

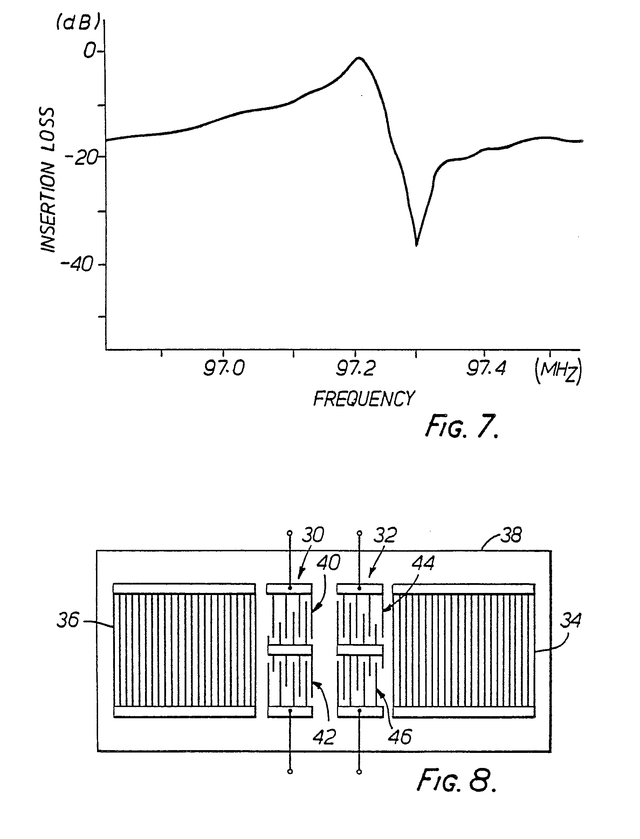

With the arrangement shown in Figure 6, the transducer means no longer generates the higher transverse mode waves, but generates only the fundamental transverse mode wave. As a result, spurious results from higher transverse mode waves is reduced as shown in Figure 7.

Such an apodized interdigital transducer may be applied to both an input transducer 30 and an output transducer 32 of a two-port surface acoustic wave resonator device as shown in Figure 8.

In the above embodiments, substrates made entirely of piezoelectric material can be used; instead, substrates covered with piezoelectric film can be used.

The piezoelectrice material is preferably lithium tantalate (LiTaO$_3$), and the transducer means and grating reflector means are preferably made of aluminium (Al) formed on the LiTaO$_3$ substrate to obtain excellent resonance characteristics.

A small amount of at least either copper or silicon is advantageously included in the aluminium of the grating reflectors to prevent damage originating from stress caused by surface acoustic waves.

## Claims

1. A surface acoustic resonator device comprising: a substrate (10) comprising or including a layer of piezoelectric material; at least one transducer means (12) disposed on the surface of the piezoelectric layer for converting an input electrical signal to surface acoustic waves propagating on the piezoelectric surface, the transducer means (12) comprising a plurality of interdigitated transducers (14, 16) and grating reflector means (18, 20) disposed on the piezoelectric surface (10) for reflecting the surface acoustic waves so that they can resonate, the aperture length of the grating reflector means extending over at least the width of the surface acoustic wave propagation paths, characterised in that, the plurality of interdigitated transducers (14, 16) are electrically connected to each other in series between terminals to which the input electrical signal is applied and are physically aligned to form surface acoustic wave propagation paths parallel to each other.

2. A surface acoustic wave resonator device according to claim 1, wherein each interdigitated transducer (14, 16) has first and second electrodes with finger electrodes (14a, 14b; 16a, 16b) arranged in an interdigitated relationship, the second electrode of the one interdigital transducer being formed integrally with the first electrode of the adjacent interdigital transducer.

3. A surface acoustic wave resonator device according to claim 2, wherein there are two interdigitated transducers (14, 16) and the input electric signal is applied between the first electrode (14a) of the first interdigital transducer (14) and the second electrode (16b) of the second interdigital transducer (16).

4. A surface acoustic wave resonator device according to any one of the preceding claims, wherein the piezoelectric material of the substrate (10) is lithium tantalate (LiTaO$_3$), and each of the transducer means (12) and grating reflector means (18, 20) is made of aluminium.

5. A surface acoustic wave resonator device according to any one of the preceding claims, wherein the substrate (10) is made entirely of piezoelectric material.

6. A surface acoustic wave resonator device according to any one of the preceding claims, wherein the grating reflector means comprises first and second grating reflectors (18, 20) disposed on opposite sides of the transducer means (12).

7. A surface acoustic wave resonator device according to any one of the preceding claims, wherein the grating reflector means comprise a large number of parallel spaced conductors (18a, 20a).

8. A surface acoustic wave resonator device according to claim 7, wherein the conductors (18a, 20a) are interconnected along common ends (18b, 18c; 20b, 20c) of the conductors.

9. A surface acoustic wave resonator device according to claim 7 or claim 8, wherein each conductor (18a, 20a) includes aluminium and a small amount of at least either copper or silicon.

10. A surface acoustic wave resonator device according to any one of the preceding claims, wherein the effective aperture length of the grating reflector means (18, 20) is substantially the same as the total aperture length of the transducer means (12).

11. A surface acoustic wave resonator device comprising: a piezoelectric substrate (38); an input transducer means (30) disposed on the piezoelectric substrate (38) for converting an input electrical signal to surface acoustic waves propagating on the piezoelectric substrate; an output transducer means (32) disposed on the piezoelectric substrate (38) in a face to face relationship with the input transducer (30) for converting the surface acoustic waves to an electric signal, at least one of the transducer means comprising a plurality of interdigitated transducers (40, 42; 44, 46) and first and second grating reflectors (34, 36), disposed on the piezoelectric substrate (38) with the input and output transducer means (30, 32) therebetween, for reflecting the surface acoustic waves, the aperture length of the first and second grating reflectors (34, 36) extending over at least the width of said surface acoustic wave propagation paths, characterised in that, said plurality of interdigitated transducers are electrically connected to each other in series and are physically aligned in a direction perpendicular to the surface wave propagation path.

12. A surface acoustic wave resonator device according to claim 11, wherein the input and output transducer means (30, 32) comprise an equal number of interdigital transducers (40, 42; 44, 46).

13. A surface acoustic wave resonator device according to claim 11, wherein the input and output transducer means (50, 52) comprise a different number of interdigitated transducers (58; 54, 56).

14. A surface acoustic wave resonator device according to any one of claim 1 and 11 to 13, wherein each transducer (14, 16; 40, 42; 44, 46) of the transducer means (12) or at least one of the transducer means (30, 32) comprises a plurality of substantially parallel, spaced-apart conductive electrodes arranged in interdigitated relationship, with the transverse overlap between adjacent electrodes varying in the direction of the surface acoustic wave propagation.

15. A surface acoustic wave resonator device according to claim 14, wherein each transducer (14, 16; 40, 42; 44, 46) comprises two electrodes, each comprising a set of finger electrodes interdigitated with the finger electrodes of the other set, and wherein the lengths of the finger electrodes of one of the sets varies according to the cosine of the distance from one end finger electrode.

16. A surface acoustic wave resonator device according to any of claims 11 to 15, wherein the effective aperture length of the grating reflector means (18, 20) is substantially the same as the total aperture length of the interdigital transducers (14, 16).

**Patentansprüche**

1. Resonator für akustische Oberflächenwellen. Dieser Resonator mit einer Trägerschicht (10) — diese Trägerschicht entweder als eine Schicht aus piezoelektrischem Material ausgeführt oder eine Schicht aus piezoelektrischem Material aufweisend — und mit mindestens einem Wandler/Umformersystem (12) zum Umwandeln eines elektrischen Eingangssignales in akustische Oberflächenwellen, die sich dann über die piezoelektrische Fläche ausbreiten. Zum Wandler/Umformersystem (12) gehören mehrere Wandler/Umformer (14, 16), die kammförmig ineinandergreifen, und das gitterartige Reflektorsystem (18, 20), das auf der piezoelektrischen Fläche (10) derart angeordnet ist, daß von ihm die akustischen Oberflächenwellen derart reflektiert werden, daß sie in Resonanz gehen können. In der Länge sind die Gitteröffnungen so ausgelegt, daß sie sich zumindest über die ganze Breite der Ausbreitungswege der akustischen Oberflächenwellen erstrecken. Der Resonator für akustische Oberflächenwellen dadurch gekennzeichnet, daß zwischen den Anschlüssen, denen das elektrische Eingangssignal aufgeschaltet wird, die kammförmig ineinandergreifenden Wandler/Umformer (14, 16) elektrische miteinander verbunden und als Reihenschaltung ausgeführt sind, daß sie zudem auch körperlich derart ausgerichtet sind, daß sie zueinander parallele Ausbreitungswege für die akustischen Oberflächenwellen entstehen lassen.

2. Resonator für akustische Oberflächenwellen nach Anspruch 1, dadurch gekennzeichnet, daß die kammförmig ineinandergreifenden Wandler/Umformer (14, 16) erste und zweite Elektroden mit den Fingerelektroden (14a, 14b, 16a und 16b) haben, die kammförmig ineinandergreifen, wobei die zweite Elektrode des einen der kammförmig ineinandergreifenden Wandlers/Umformers mit der ersten Elektrode des benachbarten Wandlers/Umformers integral gearbeitet ist.

3. Resonator für akustische Oberflächenwellen nach Anspruch 2, dadurch gekennzeichnet, daß zwei kammförmig ineinandergreifende Wandler/Umformer (14, 16) vorhanden sind und daß das elektrische Eingangssignal zwischen der ersten Elektrode (14a) des ersten Wandlers/Umformers (14) und der zweiten Elektrode (16a) des zweiten Wandlers/Umformers (16) aufgeschaltet weid.

4. Resonator für akustische Oberflächenwellen nach irgendeinem der vorhergehenden Ansprüchen, dadurch gekennzeichnet, daß für die Trägerschicht (10) als piezoelektrisches Material Lithiumtantalat (LiTaO₃) verwendet wird und die Wandler/Umformersysteme (12) und das Reflektorsystem (18, 20) aus Aluminium hergestellt sind.

5. Resonator für akustische Oberflächenwellen nach irgendeinem der vorhergehenden Ansprüche, dadurch gekennzeichnet, daß die Trägerschicht (10) vollständig aus einem piezoelektrischem Material besteht.

6. Resonator für akustische Oberflächenwellen nach irgendeinem der vorhergehenden Ansprüche dadurch gekennzeichnet, daß das gitterartige Reflektorsystem aus einem ersten Reflektorgitter (18) und aus einem zweiten Reflektorgitter (20) besteht, die dem Wandlersystem (12) an einander gegenüberliegenden Seiten zugeordnet sind.

7. Resonator für akustische Oberflächenwellen nach irgendeinem der vorhergehenden Ansprüche, dadurch gekennzeichnet, daß zu dem gitterartigen Reflektorsystem eine große Anzahl von zueinander parallelen Leitern (18a, 20a) gehören.

8. Resonator für akustische Oberflächenwellen nach Anspruch 7, dadurch gekennzeichnet, daß daß die Leiterelemente (18a, 20a) über die gemeinsamen Enden (17b, 18c; 20b, 20c) der Leiterelemente miteinander in Verbindung stehen.

9. Resonator für akustische Oberflächenwellen nach Anspruch 7 und Anspruch 8, dadurch gekennzeichnet, daß ein jeder der Leiter (18a, 20a) aus Aluminium und aus einem kleinen Anteil von zumindest Kupfer oder Silizium hergestellt ist.

10. Resonator für akustische Oberflächenwellen nach irgendeinem der vorhergehenden Ansprüche, dadurch gekennzeichnet, daß die effektive Öffnungslänge der Gitterreflektorensysteme (18, 20) im wesentlichen gleich der gesamten Öffnungslänge des Wandersystems/-Umformersystems (12) ist.

11. Resonator für akustische Oberflächenwellen. Zu diesem Resonator gehören: — eine piezoelektrische Trägerschicht (38); ein auf dieser piezoelektrischen Trägerschicht (38) angeordneter Eingangswandler (30), der ein elektrisches Eingangssignal in akustische und sich auf der piezoelektrischen Trägerschicht ausbreitenden Oberflächenwellen umzuwandeln hat; ein dem Eingangswandler (30) gegenüber auf der piezoelektrischen Trägerschicht (38) angeordneter Ausgangswandler (32), der die akustischen Oberflächenwellen in ein elektrisches Signal umsetzt, wobei mindestens eines der Wandlersysteme aus mehreren kammförmig ineinander eingreifenden Wandlern/Umformern (40, 42, 44, 46) und aus ersten und zweiten Gitterreflektoren (34, 36) besteht, die auf der piezoelektrischen Trägerschicht (38) derart angeordnet sind, daß das Eingangswandlersystem (30) und das Ausgangswandlersystem (32) sich zwischen ihnen befindet und dadurch die akustischen Oberflächenwellen reflektiert werden. Die Öffnungslänge der ersten und zweiten Gitterreflektoren (34, 36) erstreckt sich zumindest über die Breite der Ausbreitungswege für die akustischen Oberflächenwellen. Das Resonatorsystem dadurch gekennzeichnet, daß die mehreren kammförmig ineinandergreifenden Wandler/Umformer elektrische in Reihegeschaltet und darüber hinaus körperlich auch noch quer zur Richtung der Oberflächenwellenausbreitung ausgerichtet sind.

12. Resonator für akustische Oberflächenwellen nach Anspruch 11, dadurch gekennzeichnet, daß sowohl das Eingangswandlersystem (30) als auch das Ausgangswandlersystem (32) die gleiche Anzahl an kammförmig ineinandergreifenden Wandlern/Umformern (40, 42; 44, 46) aufweisen.

13. Resonator für akustische Oberflächenwellen nach Anspruch 11, dadurch gekennzeichnet, daß das Eingangswandlersystem (50) und das Ausgangswandlersystem (52) jeweils eine verschiedene Anzahl von kammförmig ineinandergreifenden Wandlern/Umformern (58, 54, 56) aufweisen.

14. Resonator für akustische Oberflächenwellen nach iregendeinem der Ansprüche 1 und 11 bis 13, dadurch gekennzeichnet, daß zu einem jedem Wandler-Umformer (14, 16; 40, 42; 44, 46) des Wandlersystemes (12) oder zumindest eines der Wandlersysteme (30, 32) mehrere im wesentlichen zueinander parallele und im Abstand zueinander angeordnete elektrisch leitende Elektroden aufweist, die einander kammförmig zugeordnet sind, wobei sich die Querüberlappung zwischen einander benachbarten Elektroden in der Ausbreitungsrichtung der akustischen Wellen verändert.

15. Resonator für akustische Oberflächenwellen nach Anspruch 14, dadurch gekennzeichnet, daß ein jeder Wandler/Umformer (14, 16; 40, 42; 44, 46) zwei Elektroden mit einem Elektrodenfingersatz hat, wobei ein jeder Fingersatz zu den Elektroden des anderen Fingersatz kammförmig zugeordnet ist und wobei sich die Länge der Fingerelektroden des einen Satzes entsprechend dem Kosinus des Abstandes von einer Endfingerelektroden verändert.

16. Resonator für akustische Oberflächenwellen nach einem jeder der Ansprüche 11 bis 15, dadurch gekennzeichnet, daß die effektive Öffnungslänge der Gitterreflektorsysteme (18, 20) im wesentlichen gleich der gesamten Öffnungslänge der kammförmig ineinandergreifenden Wandler/Umformer (14, 16) ist.

**Revendications**

1. Dispositif résonateur pour ondes acoustiques de surface qui comprend: un substrat (10) comportant ou incluant une couche de matière piézo-électrique; au moins un élément transducteur (12) disposé à la surface de la couche piézo-électrique pour convertir un signal électrique d'entrée en ondes acoustiques de surface se propageant sur la surface piézo-électrique, l'élément transducteur (12) comprenant un certain nombre de transducteurs imbriqués ou intercalés (14, 16) et des grilles réflectrices (18, 20) disposées sur la surface piézo-électrique (10) afin de réfléchir les ondes acoustiques de surface de sorte qu'elles peuvent résonner, la longueur d'ouverture des grilles réflectrices s'étendant sur, au moins, la largeur des trajets de propagation des ondes acoustiques de surface, caractérisé en ce que les différents transducteurs imbriqués ou intercalés (14, 16) sont reliés électriquement l'un à l'autre en série entre les bornes auxquelles le signal électrique d'entrée est appliqué et sont alignés physiquement afin de former des trajets de propagation pour les ondes acoustiques de surface qui sont parallèles l'un à l'autre.

2. Dispositif résonateur d'ondes acoustiques de surface selon la revendication 1, dans lequel chaque transducteur imbriqué (14, 16) a des premières et des secondes électrodes comportant des doigts (14a, 14b; 16a, 16b) intercalées ou imbriquées, la seconde électrode de chaque transducteur intercalé faisant partie intégrante de la première électrode du transducteur imbriqué adjacent.

3. Dispositif résonateur d'ondes acoustiques de surface selon la revendication 2, dans lequel il y a deux transducteurs imbriqués (14, 16) et le signal électrique d'entrée est appliqué entre la première électrode (14a) du premier transducteur imbriqué (14) et la seconde électrode (16b) du second transducteur imbriqué (16).

4. Dispositif résonateur d'ondes acoustiques de surface selon l'une quelconque des revendications précédentes dans lequel la matière piézo-électrique du substrat (10) est le tantalate de lithium (LiTaO₃), et où chacun des transducteurs (12) et chacune des grilles réflectrices (18, 20) sont en aluminium.

5. Dispositif résonateur d'ondes acoustiques de surface selon l'une quelconque des revendications précédentes, dans lequel le substrate (10) est fait entièrement d'une matière piézo-électrique.

6. Dispositif résonateur d'ondes acoustiques de surface selon l'une quelconque des revendications précédentes, dans lequel les grilles réflectrices comprennent deux grilles (18, 20) disposées de part d'autre du transducteur (12).

7. Dispositif résonateur d'ondes acoustiques de surface selon l'une quelconque des revendications précédentes dans lequel les grilles réflectrices comprennent un grand nombre de conducteurs parallèles espacés (18a, 20a).

8. Dispositif résonateur d'ondes acoustiques de surface selon la revendication 7, dans lequel les conducteurs (18a, 20a) sont interconnectés le long de leurs extrémités communes (18b, 18c; 20b, 20c).

9. Dispositif résonateur d'ondes acoustiques de surface selon la revendication 7 ou 8, dans lequel chaque conducteur (18a, 20a) est en aluminium et contient une petite quantité de cuivre et/de silicium.

10. Dispositif résonateur d'ondes acoustiques de surface selon l'une quelconques des revendications précédentes, dans lequel la longueur d'ouverture effective des grilles réflectrices (18, 20) est sensiblement la même que la longueur d'ouverture total du transducteur (12).

11. Dispositif résonateur d'ondes acoustiques de surface qui comprend: un substrat piézo-électrique (38), un transducteur d'entrée (30) disposé sur le substrat piézo-électrique (38) pour convertir un signal électrique d'entrée en ondes acoustiques de surface se propageant sur le substrat piézo-électrique, un transducteur de sortie (32) disposé sur le substrat piézo-électrique (38) en face du transducteur d'entrée (30) afin de convertir les ondes acoustiques de surface en un signal électrique, l'un, au moins, des transducteurs comprenant un certain nombre d'éléments transducteurs imbriqués ou intercalés (40, 42; 44, 46) et des premières et des secondes grilles réflectrices (34, 36) disposées sur le substrat piézo-électrique (38) avec les transducteurs d'entrée et de sortie (30, 32) entre elles, afin de réfléchir les ondes acoustiques de surface, la longueur d'ouverture de la première et de la seconde grilles réflectrices (34, 36), s'étendant sur, au moins, la largeur desdits trajets de propagation d'ondes acoustiques de surface, caractérisé en ce que lesdits éléments transducteurs imbriqués sont reliés électriquement en série et sont physiquement alignés dans une direction perpendiculaire au trajet de propagation des ondes acoustiques de surface.

12. Dispositif résonateur d'ondes acoustiques de surface selon la revendication 11, dans lequel les transducteurs d'entrée et de sortie (30, 32) comprennent un nombre égal d'éléments transducteurs intercalés ou imbriqués (40, 42; 44, 46).

13. Dispositif résonateur d'ondes acoustiques de surface selon la revendication 11, dans lequel les éléments transducteurs d'entrée et de sortie (50, 52) comprennent un nombre différent de transducteurs intercalés ou imbriqués (58, 54, 56).

14. Dispositif résonateur d'ondes acoustiques de surface selon l'une quelconque des revendications 1 et 11 à 13, dans lequel chaque élément transducteur (14, 16; 40, 42; 44, 46) du dispositif (12) ou bien, au moins, l'un des transducteurs (30, 32) comprend un certain nombre d'électrodes conductrices espacées pratiquement parallèles imbriquées ou intercalées, le recouvrement transversal entre les électrodes adjacentes variant dans la direction de propagation des ondes acoustiques de surface.

15. Dispositif résonateur d'ondes acoustiques de surface selon la revendication 14, dans lequel chaque élément transducteur (14, 16; 40, 42; 44, 46) comprend deux électrodes, dont chacune se compose d'une série de doigts intercalés ou imbriqués avec les doigts de l'autre série, et où les longueurs de doigts de l'une des séries varient selon le cosinus de la distance par rapport à un doigt d'électrode d'extrémité.

16. Dispositif résonateur d'ondes acoustiques de surface selon l'une quelconque des revendications 11 à 15, dans lequel la longueur d'ouverture effective des grilles réflectrices (18, 20) est sensiblement la même que la longueur d'ouverture totale des transducteurs imbriqués ou intercalés (14, 16).

*Fig. 1.*

0 056 690

Fig. 2.

FIG. 3.

0 056 690

FIG. 4.

FIG. 5.

FIG. 6.

FIG. 7.

FIG. 8.